# EUROPEAN PATENT SPECIFICATION

(11) **EP 0 389 025 B1**
(45) Date of publication and mention of the grant of the patent: **03.02.1993**
(21) Application number: 90200551.1
(22) Date of filing: 09.03.1990
(51) Int. Cl.: H03D 9/06, H01P 5/10

(54) **Microwave frequency converter**
Mikrowellen-Frequenzumsetzer
Convertisseur de fréquence pour micro-ondes

(30) Priority: 24.03.1989 IT 1989889
(43) Date of publication of application: 26.09.1990
(73) Proprietor: SIEMENS TELECOMUNICAZIONI S.P.A., 20060 Cassina de Pecchi (Milano) (IT)
(72) Inventor: Crema, Stefano, I-20142 Milano (IT); Piloni, Marco, I-20090 Vimodrone (Milano) (IT)

(56) References cited:
- DE-A- 2 525 468
- FR-A- 2 389 270
- MICROWAVE JOURNAL. vol. 26, no. 10, October 1983, DEDHAM US pages 140 - 141; N. M. El Minyawi: "A New Microstrip-Slotline Transition"

## Description

The present invention relates to the field of radio signal frequency conversion performed mainly but not only by receivers operating in the microwave frequency range and more specifically to a microwave frequency converter.

As is known the input stage of a radio signal receiver usually includes a low noise figure amplifier placed immediately after the antenna and whose output signal reaches a frequency converter device. Said device translates the entire band of the signal to reception radio frequency around a lower intermediate frequency.

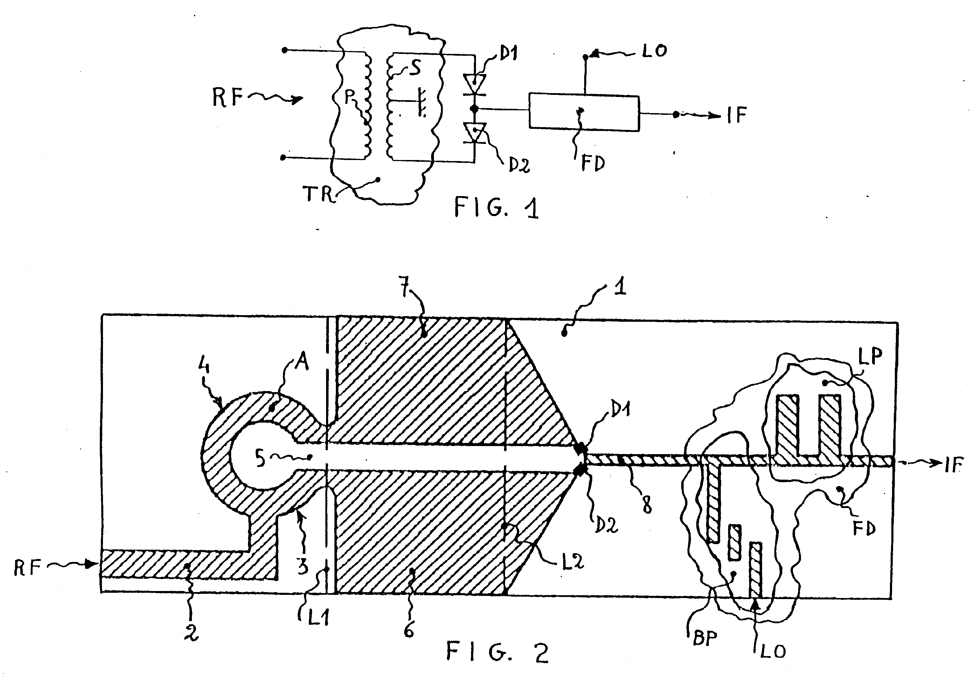

The most general example of a frequency converter device is the one shown in FIG. 1 and will be described below. It consists of a balanced mixer made up of two or more appropriately connected diodes connected to a diplexer filter which separates the local oscillator signal from the reception signal translated to the intermediate frequency.

A first known receiver input stage structure for microwave structures is the one consisting of a parametric amplifier connected to a cascaded frequency converter.

The converter employed in this first structure is usually the one of the most general example and can be accomplished either directly in a wave-guide or by adopting a fin-line configuration.

Examples of wave-guide converters are described in the volume entitled "Microwave Mixers" by S. A. Maas and published by Artech House; these converters have the advantage of possessing low conversion losses. But they are cumbersome, difficult to make mainly because of the required machining accuracy, and do not allow the use of chip or beam-lead components without complicated assembly work.

Examples of fin-line converters are described in the volume entitled "E-Plane Integrated Circuits" by P. Bhartia and P. Pramanick and published by Artech House; these converters have the advantage of allowing the use of chip or beam-lead components because they use a semiplanar technology.

But these converters are cumbersome and, compared with the guide configurations, show higher conversion losses and do not allow easy tuning operations. A second known receiver input stage structure for microwave signals is the one where both the low-noise amplifier and the frequency converter are obtained with thin film planar technology.

In this case also, the frequency converter used is usually the one in the more general example mentioned above.

The advantages of this second input structure compared with the first are the result mainly of the use of planar technology. This allows both considerable reduction of the size of the circuits and less construction difficulty thanks to the less critical design parameters and the use of chip or beam lead components.

The converters used in this second structure comprise necessarily microstrip circuits and slotline circuits.

Examples of microstrip and slotline circuit production are given in the volume entitled "Microstrip Lines and Slotlines" by K. C. Gupta R. Garg, I. S. Bahl published by Artech House.

The slotline part is principally used for propagation of the radiofrequency reception signal to the two mixer diodes, allowing their operation in balanced mode; said operation can take place only if the radiofrequency signal at the converter input sees the two mixer diodes in series (FIGS. 1 and 2). The remaining circuits of the structure, i.e. the low-noise amplifier, the mixer input circuit and the diplexer filter are microstrip.

The microstrip and slotline circuits, both made on a single dielectric substrate, are obtained working both faces of the substrate. More specifically the microstrip circuits are made on the face of the substrate opposite that on which are made the slotline circuits. See FR-A-2 389 270 for example.

Concerning this, since the amplifier circuits are made with microstrip and the converter input with slotline, there arises the problem of transition from microstrip to slotline. This involves the solution of several technological problems which arise from the operation of alignment of the tracks on the two faces of the substrate, said alignment growing more critical with increasing frequency of the input signal.

Therefore the object of the present invention is to overcome the shortcomings and problems outlined above and indicate a microwave frequency converter made by the thin film technique and comprising both microstrip and slotline circuits and a transition from microstrip to slotline allowing obtaining of said circuits on one face of the dielectric substrate and thus avoiding the troublesome operation of track alignment typical of the previous transitions.

The transition from microstrip to slotline used in the converter which is the object of the present invention is the one described in the article entitled "A New Microstrip-Slotline Transition" by L. M. E1 Minyawi published in Microwave Journal, October 1983.

Although the article mentioned proposes a very general use of the transition, it still does not appear to have been used in the design of a balanced-frequency converter.

To achieve the goals indicated above, the present invention's object is a microwave frequency converter as described in claim 1.

Other goals and advantages of the present invention will be made clear by the following detailed description of an example of embodiment thereof and the annexed drawings given purely as nonlimiting examples wherein:
FIG. 1 shows the equivalent circuit of a frequency converter to which may be ascribed the frequency converter which is the object of the present invention,
FIG. 2 shows a circuit of the frequency converter which is the object of the present invention, and
FIGS. 3 and 4 represent diagrams of the electrical characteristics of a converter prototype similar to the one shown in FIG. 2.

With reference to FIG. 1, the symbol TR indicates a transformer having a primary winding P and a secondary winding S whose central point is connected to ground. At the two ends of the secondary windings are connected two diodes D1 and D2 respectively in series. Between the cathode of the diode D1 and the anode of the diode D2 there branches off a connection to the first port of a diplexer filter FD, to a second port of which reaches a sinusoidal signal of the local oscillator LO.

The local oscillator signal LO is applied through the diplexer filter FD to the connecting point of the two diodes D1 and D2 and controls the conduction thereof alternating on each half-wave.

The transformer TR and the two diodes D1 and D2 form a singly balanced mixer.

The reception signal RF present at the primary P of the transformer TR is transferred to the secondary S and placed at the ends of the two diodes in series D1 and D2. By connection to ground of the central point of the secondary winding S the voltage of RF on the diodes D1 and D2 is balanced in relation to the ground potential. If the diodes have identical voltage and current characteristics said ground potential coincides with the potential of the point of connection of the two diodes, which can therefore be considered a virtual ground point for the signal RF.

As is known, during conduction of the diodes D1 and D2, the frequency band of the signal RF is translated around an intermediate frequency IF given by the difference between the centre band frequency signal RF and the local oscillator signal LO. Said intermediate frequency IF reaches the first port of the filter FD, which allows it to pass only toward a third port thereof.

In the particular nonlimiting example of this invention there is described a converter which operates in the Ku band (26-40GHz) and more precisely the signal RF has a band of 1000MHz centred around a frequency of 27.5GHz; the local oscillator signal LO has a frequency of 15.5GHz and consequently the intermediate frequency is 12GHz.

The principal functions of the diplexer filter FD are coupling the signal LO to the diodes D1 and D2, decoupling the signal RF from the second and third ports of said filter, and taking the signal IF coming from the diodes, decoupling it from the second port of FD.

With reference to FIG. 2 where the same elements as in FIG. 1 are indicated by the same symbols there can be seen the upper face of an Alumina (Al₂O₃) chip 1 which supports the circuits of a frequency converter in accordance with the equivalent circuit shown in FIG. 1. Said circuits are embodied by thin film technology, which is particularly well suited to the operating frequencies of the converter.

The bottom face of the chip has metalization extending over the entire surface except the area included between the broken lines indicated by L1 and L2.

The radiofrequency signal RF reaches a radio frequency port of the converter, said port coinciding with the unconnected end of a microstrip line 2 whose other end is connected to a broken ring A also made of microstrip.

The ring A is formed of two parts 3 and 4 of different lengths broken by an opening 5; part 3 is connected on one side to the microstrip 2 and on the other to a trapezoidal metalization plane 6. Part 4 is connected on one side to the microstrip 2 and on the other side to a metalization plane 7 identical with plane 6.

The two metalization planes 6 and 7 are separated by a distance equal to that of the opening 5 of the ring A thus parallel and mirrored with each other and thus forming a slotline transmission line.

The transition from microstrip to slotline is obtained by coupling the broken ring A with the two metalization planes 6 and 7.

The pointed end of the plane 7 opposite that connected to the ring A is connected to the anode of a diode D1 whose cathode is connected to a microstrip 8. The pointed end of the plane 6 opposite that connected to the ring A is connected to the cathode of a diode D2 whose anode is connected to the microstrip 8.

The length of the part of the ring A indicated by 3 is such that a sinusoidal voltage at the centre-band frequency of the signal RF is 90° phase-shifted (one-fourth wave) between the input and the output of said part. The length of the part of the ring A indicated by 4 is such that a sinusoidal voltage at the centre-band frequency of the signal RF is 270° phase-shifted (three-quarters wave) between the input and the output of said part. Therefore two sinusoidal voltages having the centre-band frequency of the signal RF appear on the two faces of the opening 5 of the ring A 180° phase-shifted and, since the planes 6 and 7 have the same length, the same phase-shift is maintained at the ends of the diodes D1 and D2.

The microstrip 8 is connected to the first port of the diplexer filter FD. This filter, which is a microstrip filter of known type, is made up of two filtering sections. A first filtering section BP is placed between the microstrip 8 and a second filtering section LP.

The section BP is a 15.5GHz band-pass filter made with quarter-wave resonators appropriately coupled and reached by the local oscillator signal LO present at the second port of the diplexer filter FD. The section LP is a band-pass filter having a 13GHz cutoff frequency. Both of said filtering sections reject the radiofrequency signal RF present on the microstrip 8.

The 15.5GHz signal LO is allowed to pass by the filter BP to the diodes D1 and D2 while it is rejected in phase by the filter LP which at this frequency presents an open circuit.

The two diodes employed for frequency conversion are the Schottky gallium arsenide barrier type mounted in beam-lead configuration.

The low parasite reactances of these diodes make it possible to obtain very extended frequency bands.

The 12GHz intermediate frequency signal IF coming from the diodes D1 and D2 passes unchanged from the filter LP to the third port of the diplexer filter FD while it is rejected in phase by the filter BP which at this frequency presents an open circuit.

The circuitry of FIG. 2 regarding the coupling between the input signal RF and the diodes D1 and D2 is based on the electrical diagram of FIG. 1. Thus the singly balanced mixer of FIG. 1 is formed by the broken ring A together with the two metalization planes 6 and 7 and the diodes D1 and D2.

The voltage of the signal RF at the ends of the diodes in series D1 and D2 of FIG. 2, as in the circuit of FIG. 1, is balanced in relation to the central point of the connection of the two diodes, whence branches the connection to the diplexer filter FD.

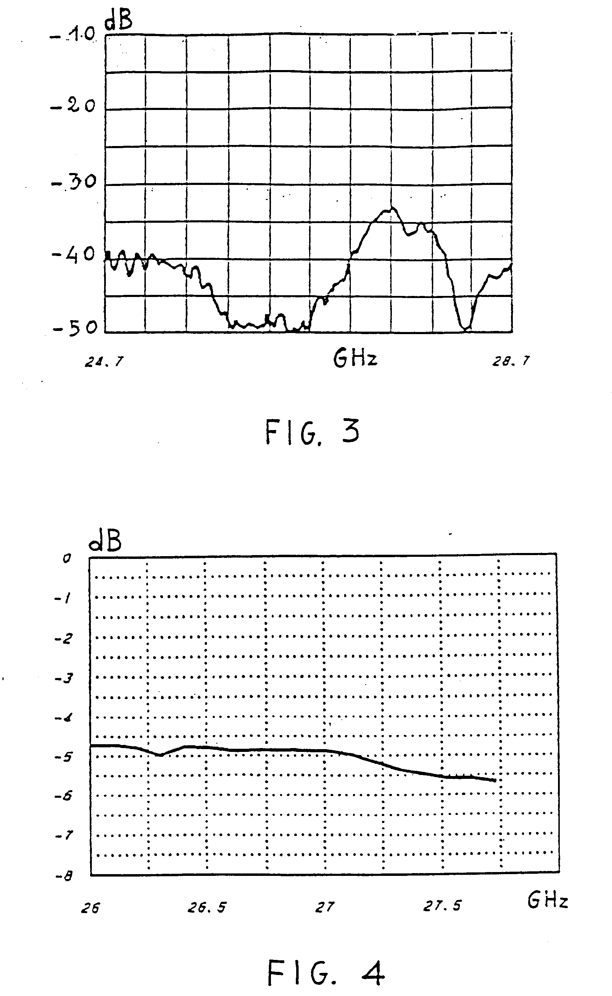

FIG. 3 shows the behaviour of the electrical insulation which a converter prototype, similar to that described in the example, shows between the input port of the radiofrequency signal RF and the input signal of the local oscillator LO. The chart in FIG. 3 has on the abscissa the frequency of the reception signal RF and on the ordinate the residual power of the signal RF expressed in dB and measured at the input port of the signal LO. As may be seen from the chart the converter shows good insulation between the two ports. The electrical insulation between the input port of the radiofrequency signal RF and the output port of the intermediate frequency signal IF shows a behaviour similar to that of FIG. 3.

FIG. 4 shows the behaviour of the conversion gain of the same converter prototype. The chart in FIG. 4 has on the abscissa the frequency of the reception signal RF and on the ordinate the value of the conversion gain expressed in dB. As may be seen from the chart, the conversion gain is never less than -5.5dB in the entire range of frequencies considered.

There are no basic limitations on the use of the converter which is the object of the present invention, and it can be used both in the input stage of receivers and in the output stage of transmitters. The diplexer filter LP will have to be appropriately sized case by case.

As concerns the operating frequency of the converter, the limits are those of thin film technology in the higher frequencies. From experimental results on some converters similar to those described, it can be reasonably stated that the field of application of the device can be extended to that of millimetric waves (over 30GHz).

From the description given the advantages of the microwave frequency converter which is the object of the present invention are clear. In particular they are the fact that the fabrication thereof does not present great technological difficulties and offers good reproducibility of the thin film circuit.

## Claims

1. Microwave frequency converter comprising two series-connected frequency mixer diodes (D1,D2) placed on a dielectric substrate (2,3,4,7,6) which comprises first thin film transmission line (2,3,4,7,6) carrying to said diodes a microwave input signal (RF) to be transposed inside of a lower frequency band, and a second thin film transmission line (8) carrying to said diodes a local (8) (LO) oscillator signal (FD) and to a diplexer filter (FD) an intermediate frequency signal, coming from the diodes, having a frequency band corresponding to the difference between the frequencies belonging to the band of said microwave input signal and the frequency of said local oscillator signal, characterized in that a first face of said dielectric substrate comprises:
- a conductive ring (A) which has break (5) having two sides at a point of its metallization;
- a first conductive line (2), carrying said microwave input signal (RF), connected with said conductive ring (A), the point of connection and said break (5) delimit on the ring (A) two conductive paths (3, 4) having a lenght such that a sinusoidal signal, at the centre-band frequency of said microwave input signal (RF), reaches the two sides of said break (5) with 180° phase-shift;
- two conductive planes (6, 7) parallel to each other, spaced as the width of said break (5) and connected to said conductive ring (A) at the two sides of its break (5) obtaining a channel without metallization extending said break (5) until said mixer diodes (D1, D2), being the two ends of the series connection of the diodes respectively connected to said conductive plane (6, 7);
- a second conductive line (8) connected between the central point of the series connection of said diodes (D1, D2) and a first port of said diplexer filter (FD);
- third conductive lines, opportunely spaced from each other, forming said diplexer filter (FD);
further characterized in that on a second face of said dielectric substrate (1) a metallization is deposited extending to the entire surface of said second face except a zone (L1, L2) placed mainly underneat said two conductive planes (6, 7).

2. Microwave frequency converter in accordance with the claim 1, characterized in that said first thin film transmission lines comprise a microstrip line and a slotline, the microstrip line including said first conductive line (2), said conductive ring (A) and the respective underneat metallization, the slotline including said two conductive planes (6, 7); and in that said second transmission line comprises said second conductive line (8) and the respective underneat metallization.

3. Microwave frequency converter in accordance with the claim 1, characterized in that said diplexer filter (FD) includes a first band-pass filtering section (BP) connected to said first port and to a second port of the filter feeded by the local oscillator signal (LO), and a second band-pass filtering section (LP) connected to said first port and to a third port of the filter emitting said intermediate frequency signal (IF) coming from said mixer diodes; the first filtering section (BP) lets pass the local oscillator signal (LO) and rejects in phase said intermediate frequency signal (IF); the second filtering section (BP) lets pass said intermediate frequency signal (IF) and rejects in phase the local oscillator signal (LO).

4. Microwave frequency converter in accordance with the claim 1, characterized in that said conductive planes (6, 7) have a form similar to a right-angled trapezium in which the corners delimited by the oblique sides and the major bases of said planes are respectivety connected to the ends of the series of said diodes (D1, D2).

## Patentansprüche

1. Mikrowellen-Frequenzumsetzer mit zwei in Reihe geschalteten Mischdioden (D1,D2) auf einem dielektrischen Substrat (1), der eine erste Dünnfilm-Übertragungsleitung (2,3,4,7,6) zur Übertragung des in ein niedrigeres Frequenzband umzusetzenden Mikrowellensignals (RF) zu den obengenannten Dioden enthält, sowie eine zweite Dünnfilm-Übertragungsleitung zur Übertragung eines Lokaloszillator-Signals (LO) und eines von den Dioden kommenden ZF-Signals mit einem, der Frequenzdifferenz zwischen den obengenannten Mikrowellen-Eingangssignalen und der Frequenz des obengenannten Lokaloszillator-Signals entsprechenden Frequenzbandes enthält, dadurch gekennzeichnet, daß die eine Seite des obengenannten Substrats folgende Elemente aufweist:
- einen leitenden Ring (A) mit einem Durchbruch (5), dessen metallisierten Seiten sich gegenüberliegen;
- eine erste, das obengenannte Mikrowellensignal (RF) führende Leiterbahn (2), die mit dem obengenannten leitenden Ring (A), dem Verbindungpunkt und dem obengenannten Durchbruch (5) verbunden ist und auf dem Ring (A) zwei Leiterbahnen (3,4) bestimmter Länge bildet, sodaß ein Sinussignal mit der Mittenfrequenz des obengenannten Mikrowellen-Einganssignals (RF) die beiden Seiten des obengenannten Durchbruchs (5) mit einer Phasenverschiebung von 180° erreicht;
- zwei zueinander parallele Leiterplatten (6,7) mit dem gleichen Abstand des obengenannten Durchbruchs (5), die mit dem obengenannten leitenden Ring (A) an den beiden Seiten des Durchbruchs (5) verbunden sind, sodaß ein nicht metallisierter Kanal ensteht, der den obengenannten Durchbruch (5) bis zu den Mischdioden (D1,D2) ausdehnt, während die beiden Enden der in Serie geschalteten Dioden jeweils mit den obengenannten Leiterplatten (6,7) verbunden sind;
- eine zweite an den Zentralpunkt der in Serie geschalteten Dioden (D1,D2) angeschlossene Leiterbahn (8) und ein erster Port des obengenannten Diplexer-Filters (FD);
- einige dritte Leiterbahnen in passendem Abstand, die das obengenannte Diplexer-Filter bilden;
weiterhin dadurch gekennzeichnet, daß auf der zweiten Seite des obengenannten Substrats (1) eine Metallisierung aufgetragen ist, die die gesamte Oberfläche der obengenannten zweiten Seite abdeckt, bis auf eine Zone (L1,L2), die sich hauptsächlich unterhalb der beiden Leiterplatten (6,7) befindet.

2. Mikrowellen-Frequenzumsetzer in Übereinstimmung mit Patentanspruch 1, dadurch gekennzeichnet, daß die erste Dünnfilm-Übertragungsleitung einen Mikrostrip sowie eine Slotted Line enthält, wobei der Mikrostrip die obengenannte erste Leiterbahn (2), den obengenannten leitenden Ring mit entsprechender darunterliegender Metallisierung, und die Slotted Line die beiden obengenannten Leiterplatten (6,7) enthält; sowie dadurch, daß die obengenannte zweite Übertragungsleitung die obengenannte zweite Leiterbahn (8) und die entsprechende darunterliegende Metallisierung beinhaltet.

3. Mikrowellen-Frequenzumsetzer in Übereinstimmung mit Patentanspruch 1, dadurch gekennzeichnet, daß das obengenannte Diplexer-Filter (FD) sowohl einen ersten Bandpaß-Filterabschnitt (BP), der mit dem oben angegebenen ersten Port und mit einem zweiten, das Lokal-Oszillatorsignal (LO) führenden Port des Filters verbunden ist, als auch einen zweiten Tiefpaß-Filterabschnitt (LP) beinhaltet, der sowohl mit dem oben angegebenen ersten Port als auch mit einem zweiten, das obengenannte, von den Mischdioden kommende ZF-Signal (IF) führenden Port des Filters verbunden ist; der zweite Filterabschnitt (BP) läßt das oben angegebene ZF-Signal (IF) durch und sperrt das phasengleiche Lokal-Oszillatorsignal (LO).

4. Mikrowellen-Frequenzumsetzer in Übereinstimmung mit Patentanspruch 1, dadurch gekennzeichnet, daß die oben genannten Leiterplatten (6,7) eine einem rechtwinkligen Trapez ähnliche Form aufweisen, in welchem die Ecken durch die schrägen Seiten begrenzt sind und in welchem die Mauptbasis der oben angegebenen Platten jeweils mit den Enden der oben angegebenen, in Serie geschalteten Dioden (D1,D2) verbunden ist.

## Revendications

1. Convertisseur de fréquence micro-onde comprenant deux diodes mélangeuses de fréquence (D1, D2) connectées en série, placées sur un substrat diélectrique (1) qui comporte des premières lignes de transmission à couches minces (2, 3, 4, 7, 6) qui amènent aux diodes un signal d'entrée micro-onde (RF) devant être transposé vers une bande de fréquence inférieure, et une seconde ligne de transmission à couches minces (8) qui amène aux diodes un signal d'oscillateur local (10), et à un filtre duplexeur un signal à fréquence intermédiaire (FD), provenant des diodes, ayant une bande de fréquence qui correspond à la différence entre les fréquences appartenant à la bande du signal d'entrée micro-onde et à la fréquence du signal d'oscillateur local, caractérisé en ce qu'une première face du substrat diélectrique comprend :
- un anneau conducteur (A) qui présente une coupure (5) ayant deux côtés en un point de sa métallisation ;
- une première ligne conductrice (2) acheminant le signal d'entrée micro-onde (RF), connectée à l'anneau conducteur précité (A), le point de connexion et la coupure (5) délimitant sur l'anneau (A) deux chemins conducteurs (3, 4) ayant une longueur telle qu'un signal sinusoïdal, à la fréquence centrale de la bande du signal d'entrée micro-onde (RF) atteigne les deux côtés de la coupure (5) avec un déphasage de 180° ;
- deux plans conducteurs (6, 7), mutuellement parallèles, avec un espacement égal à la largeur de la coupure (5), et connectés à l'anneau conducteur (A) des deux côtés de sa coupure (5), pour former un canal sans métallisation qui étend la coupure (5) jusqu'aux diodes mélangeuses (D1, D2), constituant les deux extrémités de la connexion en série des diodes qui sont respectivement connectées aux plans conducteurs (6, 7) ;
- une seconde ligne conductrice (8) connectée entre le point central de la connexion en série des diodes (D1, D2) et un premier accès du filtre duplexeur (FD) ;
- des troisièmes lignes conductrices, mutuellement espacées de façon appropriée, qui forment le filtre duplexeur (FD) ;
caractérisé en outre en ce qu'une métallisation est déposée sur une seconde face du substrat diélectrique (1) et s'étend sur la totalité de la surface de cette seconde face, sauf dans une zone (L1, L2) qui est placée essentiellement sous les deux plans conducteurs (6, 7).

2. Convertisseur de fréquence micro-onde selon la revendication 1, caractérisé en ce que les premières lignes de transmission à couches minces comprennent une ligne à micro-ruban et une ligne à fente, la ligne à micro-ruban comprenant la première ligne conductrice (2), l'anneau conducteur (A) et la métallisation inférieure respective, tandis que la ligne à fente comprend les deux plans conducteurs (6, 7) ; et en ce que la seconde ligne de transmission comprend la seconde ligne conductrice (8) et la métallisation inférieure respective.

3. Convertisseur de fréquence micro-onde selon la revendication 1, caractérisé en ce que le filtre duplexeur (FD) comprend une première section de filtrage passe-bande (BP) connectée au premier accès et à un second accès du filtre qui est attaqué par le signal d'oscillateur local (LO), et une seconde section de filtrage passe-bande (LP) qui est connectée au premier accès et à un troisième accès du filtre émettant le signal à fréquence intermédiaire (IF) qui provient des diodes mélangeuses ; la première section de filtrage (BP) laisse passer le signal d'oscillateur local (LO) et elle rejette en phase le signal à fréquence intermédiaire (IF) ; et la seconde section de filtrage (BP) laisse passer le signal à fréquence intermédiaire (IF) et elle rejette en phase le signal d'oscillateur local (LO).

4. Convertisseur de fréquence micro-onde selon la revendication 1, caractérisé en ce que les plans conducteurs (6, 7) ont une forme similaire à un trapèze rectangle dans lequel les coins délimités par les côtés obliques et les grandes bases de ces plans sont respectivement connectés aux extrémités de la connexion en série des diodes (D1, D2).
